# EUROPÄISCHE PATENTANMELDUNG

(11) **EP 4 831 952 A1**
(43) Veröffentlichungstag der Anmeldung: **28.10.2026**
(21) Anmeldenummer: 26173668.0
(22) Anmeldetag: 21.04.2026
(51) Int. Cl.: G08B 25/12

(54) **DATENERFASSUNGSVORRICHTUNG IN EINER GEBÄUDEINSTALLATION**

(30) Priorität: 24.04.2025 DE 202025102254 U
(71) Anmelder: Techem Energy Services GmbH, 65760 Eschborn (DE)
(72) Erfinder: Gutmann, Norbert, 64295 Darmstadt (DE)
(74) Vertreter: Keil & Schaafhausen Patentanwälte PartGmbB

(57) **Zusammenfassung**

Es wird eine Vorrichtung für eine Gebäudeinstallation beschrieben, aufweisend ein Gehäuse (2), eine Recheneinheit (3), die zur Steuerung der Vorrichtung (1) eingerichtet ist, und eine Energieversorgungseinheit (4), wobei die Recheneinheit (3) und die Energieversorgungseinheit (4) innerhalb des Gehäuses (2) angeordnet sind, einen Schalter (20), der außen am Gehäuse (2) angeordnet und mechanisch betätigbar ist, wobei der Schalter (20) mit der Recheneinheit (3) verbunden ist und mindestens zwei Schaltstellungen (25, 26) aufweist, und wobei die Recheneinheit (3) zur Ermittlung der Schaltstellung (25, 26) des Schalters (20) eingerichtet ist. Es ist vorgesehen, dass der Schalter als optischer Schalter (20) mit einem Lichtemitter (21) und einem Lichtempfänger (22) ausgebildet ist, die in dem Gehäuse (2) beabstandet voneinander angeordnet sind, und der optische Schalter (2) ein außen an dem Gehäuse mechanisch verstellbares Schalterelement (23) aufweist, wobei der optische Schalter (20) in einer ersten mechanischen Schaltstellung (25) des Schalterelements (23) von dem Lichtemitter (21) ausgesendetes Licht dem Lichtempfänger (22) zuleitet und wobei der optische Schalter (20) in einer zweiten mechanischen Schaltstellung (26) des Schalterelements (23) von dem Lichtemitter (21) ausgesendetes Licht dem Lichtempfänger (22) nicht zuleitet.

## Beschreibung

Die Erfindung betrifft eine Vorrichtung für eine Gebäudeinstallation mit einem Gehäuse, einer Energieversorgungseinheit und einer Recheneinheit, die zur Steuerung der Vorrichtung eingerichtet ist. Eine für die Gebäudeinstallation vorgesehene Vorrichtung ist insbesondere dazu vorgesehen, in einem Gebäude oder außen an einem Gebäude angebracht zu werden und dort für Nutzer grundsätzlich frei zugänglich zu sein. Vorzugsweise ist die Vorrichtung in einem Gebäude angebracht. Damit ist die Zugänglichkeit auf Personen beschränkt, die Zugang in das Gebäude erhalten. Grundsätzlich kann auch der Zugang in den Außenbereich auf bestimmte Personen begrenzt sein. Gemäß einer bevorzugten Ausgestaltung hat durch die Art der Gebäudeinstallation vorzugsweise innerhalb des Gebäudes nur ein bestimmter Personenkreis Zugang zu der Vorrichtung und dem Gehäuse der Vorrichtung.

Die Recheneinheit und die Energieversorgungseinheit sind innerhalb des Gehäuses angeordnet. Die Vorrichtung umfasst auch einen Schalter, der außen am Gehäuse angeordnet und mechanisch betätigbar ist. Ein solcher Schalter kann durch alle Personen, die Zugang zu der Vorrichtung haben, bedient werden. Der Schalter ist mit der Recheneinheit verbunden und weist mindestens zwei Schaltstellungen auf. Die Recheneinheit ist zur Ermittlung der Schaltstellung des Schalters eingerichtet.

Damit ist der Schalter nicht ein mechanischer Ein- und Ausschalter der Vorrichtung, der die Versorgungsspannung für die Vorrichtung ein- und ausschaltet. Vielmehr ist der Schalter ein Konfigurationsschalter, dessen Schaltstellung unterschiedliche Zustände und/oder Betriebsmodi der Vorrichtung schaltet.

Mechanische Schalter, die an dem Gehäuse angeordnet sind und direkt einen elektrischen Schaltkreis schalten, müssen die elektrischen Schalteigenschaften über die Lebensdauer der Vorrichtung gewährleisten, damit die Schaltstellung des Schalters durch die Recheneinheit einfach auswertbar ist. Die elektrischen Schalteigenschaften können durch Feuchtigkeit oder andere Verunreinigungen in der Luft über die Zeit beeinträchtigt werden. Bei bestimmten Vorrichtungen, wie beispielsweise Rauchwarnmeldern oder anderen sicherheitsrelevanten Vorrichtungen, müssen alle verbauten Komponenten so ausgelegt werden, dass sie typischen Umwelteinflüssen standhalten. Dies ist teilweise auch in Normvorschriften geregelt, wie bspw. der DIN EN 14604 für Rauchwarnmelder, die vorschreibt, dass diese korrosiven Einflüsse von Schwefeldioxid als Verunreinigungen in der Luft standhalten müssen. Entsprechend ausgelegte mechanisch-elektrische Schalter sind aufwendig und teuer. Dies soll für Schalter, mit denen eine Konfiguration der Vorrichtung auf einen Betriebsmodus eingestellt werden kann, vermieden werden.

Andererseits ist bekannt, Konfigurationseinstellungen von Vorrichtungen durch Nutzer über eine Bedienschnittstelle, bspw. eine Touch-Display, mittels Tastbedienung in einer programmierten Menüstruktur einzustellen. In der Regel kann die gewählte Einstellung dann auch nur in der Menüstruktur abgelesen und überprüft werden. Dies ist umständlich und führt dazu, dass Nutzer der Vorrichtung bestimmte Einstellungen nicht vornehmen, auch weil es aufwendig ist, die eingestellte Konfiguration abzulesen, sofern nicht zusätzlich elektrische Anzeigen dafür vorgesehen sind, die jedoch Energie verbrauchen und auch in elektrischen Schaltvorgängen separat geschaltet werden müssen.

Für eine Tastbedienung an Vorrichtungen sind verschiedene, auch optisch arbeitende Taster bekannt. Beispielsweise offenbart die EP 0 900 480 B1 einen optischen Taster mit einer herkömmlichen Infrarot-Leuchtdiode, die in einer Sendeschaltung sowohl zum Senden als auch zum Empfangen optischer Daten im Halbduplex-Betrieb genutzt wird. Die Diode ist zweckmäßigerweise in einem Gehäuse mit einer zur Diode hin lichtdurchlässigen Gehäuseöffnung angeordnet, die einer Tastenfläche für manuelle Dateneingabe zugeordnet ist. Die Diode ist als Photoelement wirksam und die Steuerschaltung erfasst die von der Intensität des von der Diode empfangenen Lichtes abhängige Leerlaufspannung der Diode, um eine den Lichtdurchlass zur Diode verändernde plötzliche Abschattung der Gehäuseöffnung als manuellen Dateneingabevorgang zu registrieren. Die DE 20 2020 005 590 U1 offenbart eine kombinierte Anzeige- und Eingabeeinrichtung mit zwei Leuchtdioden und zwei Fotoelementen, die jeweils paarweise unter einer Anzeige angeordnet sind. Zwischen jedem Paar aus Leuchtdiode und Fotoelement ist ein Lichtleiter angeordnet. Eine Leuchtdiode sendet Licht zur Darstellung auf der Anzeige aus. Wenn kein Finger auf der Anzeige liegt, wird das Licht in die Umgebung abgestrahlt. Wenn ein Finger auf der Anzeige liegt, wird das Licht auf die Leuchtdiode reflektiert. Hierdurch kann im Vergleich zu dem zweiten Paar aus Leuchtdiode und Fotoelement eine Betätigung als Taster festgestellt werden. Die vorbeschriebenen Nachteile werden dadurch nicht vermieden.

Aufgabe der Erfindung ist es daher, an einer Vorrichtung eine einfache Möglichkeit zur Konfigurationseinstellung zu bieten, mit der die Konfiguration durch den Nutzer einfach außen an dem Gerät einstellbar und dauerhaft ablesbar ist und die kostengünstig realisierbar ist.

Die Aufgabe wird durch eine Vorrichtung mit den Merkmalen des Anspruchs 1 gelöst. Dafür ist an einer Vorrichtung der eingangs beschriebenen Art der Schalter als optischer Schalter mit einem Lichtemitter und einem Lichtempfänger ausgebildet, wobei Lichtemitter und Lichtempfänger in dem Gehäuse beabstandet voneinander angeordnet sind. Außen an dem Gehäuse weist der Schalter ein mechanisch verstellbares Schalterelement auf, wobei der optische Schalter in einer ersten mechanischen Schaltstellung des Schalterelements von dem Lichtemitter ausgesendetes Licht dem Lichtempfänger (zumindest teilweise) zuleitet und der optische Schalter in einer zweiten mechanischen Schaltstellung des Schalterelements von dem Lichtemitter ausgesendetes Licht dem Lichtempfänger nicht zuleitet. Maßgeblich ist, dass der optische Schalter in der ersten Schaltstellung so viel Licht zuleitet, dass eine Schaltschwelle des Lichtempfängers dieses detektiert, und in der zweiten Schaltstellung nicht so viel Licht zuleitet, dass die Schaltschwelle des Lichtempfängers dieses detektiert.

Ein solcher erfindungsgemäß vorgeschlagener Schalter ist besonders zum Einstellen einer Konfiguration der Vorrichtung geeignet. Dazu ist die Recheneinheit gemäß einer besonders bevorzugten Ausführungsform zur Konfiguration der Vorrichtung in Abhängigkeit der ermittelten Schaltstellung des Schalters eingerichtet.

Die Konfiguration der Vorrichtung kann insbesondere das Einstellen eines Betriebsmodus oder verschiedener Betriebsmodi der Vorrichtung beinhalten. Ein Betriebsmodus kann die Ansteuerung einer oder mehrerer Funktionseinheiten der Vorrichtung in einer definierten Weise beinhalten oder dadurch definiert sein. Die Ansteuerung der Funktionseinheit oder der Funktionseinheiten kann in der Recheneinheit durch Programmcodemittel vorgegeben sein, die einen Prozessor der Recheneinheit zum Ausführen von Steuerbefehlen einrichtet, wenn die Programmcodemittel in der Steuereinheit ausgeführt werden. Durch das Ausführen der Steuerbefehle werden die Funktionseinheit oder die Funktionseinheiten zum Ausführen und/oder Nichtausführen bestimmter Funktionen veranlasst. In unterschiedlichen Betriebsmodi unterscheiden sich die ausgeführten oder nicht ausgeführten Funktionen der Funktionseinheit oder der Funktionseinheiten voneinander. Verschiedene vordefinierte Betriebsmodi sind durch Programmcodemittel vorgegebene Funktionen oder Funktionsabläufe für eine Funktionseinheit oder mehrerer Funktionseinheiten der Vorrichtung.

Durch den erfindungsgemäß vorgeschlagenen optischen Schalter kann ein Nutzer der Vorrichtung in einer besonders bevorzugten Ausführungsform mehrere, vorzugsweise genau zwei, verschiedene vordefinierte Betriebsmodi von außen an dem Gehäuse der Vorrichtung einstellen und den ausgewählten Betriebsmodus aus der mechanischen Schalterstellung erkennen bzw. direkt ablesen. Weitere Anzeigemittel, wie bspw. elektrisch arbeitende und energieverbrauchende Anzeigen, sind nicht notwendig. Die optische Funktionsweise des Schalters ist auch besonders vorteilhaft, weil elektrisch arbeitende Funktionseinheiten der Vorrichtung aufgrund von Umweltbedingungen, wie bspw. Feuchtigkeit oder Verunreinigungen in der Luft, nicht beeinflusst werden. Dies vereinfacht die Zulassung von Geräten mit besonderen Sicherheitsvorschriften, bei denen beispielsweise nachzuweisen ist, dass die in dem Gehäuse verwendeten Bauteile inert sind gegen Beschädigungen durch bspw. Schwefeldioxid SO₂ in der Luft, das Korrosionen an metallischen Bauteilen auslösen kann. Dies ermöglicht es bspw. eine gesamte Elektronikeinheit der Vorrichtung gekapselt in dem Gehäuse vorzusehen und dennoch einen kostengünstigen mechanischen Schalter zur Konfigurationseinstellung an dem Gerät vorzusehen. Ferner wird für die Konfiguration von verschiedenen Betriebsmodi der Vorrichtung durch den Nutzer weder separates Inbetriebnahme- oder Konfigurationsgerät benötigt noch muss der Nutzer eine umständliche Menüführung in einer Nutzerschnittstelle der Vorrichtung bedienen.

Gemäß einer besonders bevorzugten Ausführungsform kann die Vorrichtung eine Datenerfassungsvorrichtung in einem lokalen Gebäude-Kommunikationsnetzwerk sein mit einer Sensoreinheit und/oder einer Empfangseinheit, die zum Erfassen von Daten eingerichtet ist. Eine Sensoreinheit kann insbesondere einen oder mehrere Sensoren umfassen, die Klimadaten in der Umgebung der Vorrichtung in oder an dem Gebäude erfassen. Erfindungsgemäß bevorzugte Sensoren können Temperatursensoren, Hitzesensoren, Feuchtesensoren, Gassensoren und/oder Verbrauchssensoren sein. Eine Empfangseinheit kein ein Datenempfänger mit einer Kommunikationsschnittstelle zum Empfangen von Daten sein, insbesondere von Daten eines Senors in dem zuvor definierten Sinne. Die Kommunikationsschnittstelle kann kabelgebunden oder drahtlos ausgebildet sein.

In dieser Ausführungsform weist die Vorrichtung außerdem eine Sendeeinheit auf, die zum Aussenden zumindest eines Teils der erfassten Daten in dem Gebäude-Kommunikationsnetz an einen lokalen Datensammler und/oder in einem Weitbereichsnetzwerk (WAN - Wide Area Network) und/oder in einem Internet of Things (IoT) Netzwerk an eine zentrale Datensammelstelle einrichtbar ist, wobei die Recheneinheit weiter dazu ausgebildet ist, die Sendeeinheit abhängig von der ermittelten Schaltstellung des optischen Schalters zum Aussenden zumindest des Teils der erfassten Daten einzurichten. Diese Ausführungsform ist besonders geeignet, Vorrichtungen mit einer Datenerfassung dazu einzurichten, es dem Nutzer auf einfache Weise zu ermöglichen, Einstellungen zur Erfassung und Weiterleitung von sensiblen Daten, bspw. Raumklima-Daten, d.h. von der Vorrichtung insbesondere durch Sensoren erfassten und/oder in einem lokalen (geschützten) Gebäude-Kommunikationsnetz empfangen Daten, einfach und intuitiv vorzunehmen und die vorgenommene Einstellung auf einen Blick unmittelbar am Gehäuse der Vorrichtung abzulesen.

Gemäß einer optionalen Variante der Erfindung kann die Recheneinheit dazu eingerichtet sein, Daten mit einer Kennung zu kennzeichnen, die festlegt, dass die so gekennzeichneten Daten nur innerhalb des Gebäude-Kommunikationsnetzes ausgesendet werden dürfen. Dies bedeutet, dass diese Daten nicht an einen Empfänger übertragen werden dürfen, der nicht Teil des Gebäude-Kommunikationsnetzes ist oder der diese Daten aus dem Gebäude-Kommunikationswerk exportiert. Das Gebäude-Kommunikationsnetzwerk kann auch ein logisch abgeschirmter Teil eines Gebäude-Kommunikationsnetzwerks sein, also bspw. ein Unternetzwerk einer Wohneinheit in einem Gebäude mit mehreren Wohneinheiten. In diesem Fall kann die Kennung der Daten anzeigen, dass diese Daten nicht an einen Empfänger außerhalb des Unternetzwerk übertragen werden sollen.

Gemäß einer bevorzugten Ausführungsform kann die Recheneinheit dazu ausgebildet sein, die Sendeeinheit in genau einer der mindestens zwei Schaltschaltstellungen nicht zum Aussenden aller oder zumindest des Teils der erfassten Daten einzurichten und in genau einer anderen der zumindest zwei Schaltstellungen zum Aussenden aller oder zumindest des Teils der erfassten Daten einzurichten. Eine solche Ausführungsform ist besonders vorteilhaft bei einer Vorrichtung, die zu einer datenschutzkonformen Behandlung von sensiblen Daten eingerichtet ist bzw. einrichtbar ist.

Bei den vorbeschriebenen Ausführungsformen mit Sensoreinheit und/oder Empfangseinheit und Sendeeinheit können die Sensoreinheit und/oder die Empfangseinheit und die Sendeeinheit innerhalb des Gehäuses der Vorrichtung angeordnet sein kann, so dass diese Einheiten selbst dem Nutzer im normalen Betrieb nicht zugänglich sind. Dies gilt auch für den Lichtemitter und den Lichtempfänger des optischen Schalters.

Wie bereits erläutert, kann es (insbesondere zur Abschirmung der in dem Gehäuse der Vorrichtung angeordneten Komponenten bzw. Teile der Vorrichtung) vorgesehen sein, dass das Gehäuse im Bereich des Schalters mit einer optisch transparenten Abdeckung geschlossen ist, wobei das Schalterelement des Schalters auf der optisch transparenten Abdeckung bewegbar angeordnet ist.

Gemäß einer bevorzugten Ausführungsform können mit dem Schalter genau zwei Schaltstellungen des Schalterelements (respektive Gerätekonfigurationen oder Übertragungsmodi) einstellbar sein. Hierdurch wird die Übersichtlichkeit für den Nutzer erhöht.

Gemäß einer besonders bevorzugten Ausführungsform kann die erfindungsgemäß vorgeschlagene Ausführungsform der Vorrichtung ein Rauchwarnmelder, ein Verbrauchserfassungsgerät, ein Sensorgerät und/oder ein Datensammler sein. Der Datensammler kann insbesondere ein Empfangsgerät sein, das Daten von anderen Geräten empfängt, speichert und gegebenenfalls weiter überträgt (durch Abrufen in einem Pull-Verfahren oder/oder Aussenden in einem Push-Verfahren). Diese speziellen Geräte weisen in der Regel Sensoreinheiten mit Sensoren auf, die bestimmte Funktionen des Geräts erfüllen. Diese Sensoreinheiten können innerhalb des geschlossenen Gehäuses oder außen an dem Gehäuse festgelegt sein.

Im Falle eines Rauchmelders umfasst die Sensoreinheit eine Detektorkammer mit Lufteintrittsöffnungen und Sensoren zur Rauchdetektion. Die Detektorkammer kann separat von dem die Recheneinheit umfassenden Gehäuse der Vorrichtung angeordnet sein, wobei ggf. die Detektorkammer und das die Recheneinheit umfassende Gehäuse in einem weiteren gemeinsamen äußeren Gehäuse angeordnet sein können. In diesem Fall können gemäß einer bevorzugten Ausführungsform das Schalterelement des optischen Schalters und die Verschiebeführung außen an dem äußeren Gehäuse angeordnet sein. Die Lichtemitter und Lichtempfänger können (auch unabhängig von der Anordnung von Schalterelement und Verschiebeführung) innerhalb des Gehäuses mit der Recheneinheit und der Platine, ggf. auf der Platine, angeordnet sein. Gemäß einer bevorzugten Ausführungsform der erfindungsgemäßen Vorrichtung als Rauchwarnmelder kann der Rauchwarnmelder innerhalb oder außerhalb des Gehäuses mit der Recheneinheit oder des gemeinsamen äußeren Gehäuses eine weitere Sensoreinheit zur Erfassung von Klimadaten aufweisen, insbesondere mit einem Temperatursensor zur Messung der Lufttemperatur und einem Feuchtesensor zur Messung der relativen Luftfeuchte, deren Messwerte oder mit den Messwerten aufbereitete Daten, wie bspw. Stundenmittelwerte, - je nach Schaltstellung des optischen Schalters - in der Recheneinheit oder einem separaten Datenspeicher in der Vorrichtung gespeichert werden oder nicht gespeichert werden und die gespeicherten Daten an die zentrale Datensammelstelle weiterleitbar sind oder nicht. Diese Daten, insbesondere Klimadaten, dienen nicht der eigentlichen Funktion des Rauchwarnmelders, sondern erlauben die Erhebung weiterer Daten zum Anbieten ergänzender Services, bspw. im Umfeld der Energieeinsparung und eines gesunden Wohnklimas (Raumklima).

Entsprechende Daten können auch in Verbrauchserfassungsgeräten (wie Heizkostenverteilern, Warm- oder Kaltwasserzählern, Wärmemengenzählern, Durchflusszählern), Datensammlern oder separateren Sensorgeräten (wie separaten Temperatursensoren) oder anderen Geräten zur Gebäudeinstallation wie Lichtschaltern, Steckdosen, Beleuchtungseinheiten, Bewegungsmeldern oder anderen Alarmierungseinheiten verwendet werden. Die erläuterten Merkmale zu Gehäuse und gemeinsamem äußeren Gehäuse gelten entsprechend.

In einer besonders bevorzugten Ausführungsform des erfindungsgemäß vorgeschlagenen optischen Schalters der Vorrichtung kann das Schalterelement dazu ausgebildet sein, in der ersten Schaltstellung von dem Lichtemitter ausgesendete Lichtstrahlen auf den Lichtempfänger zu reflektieren und in der zweiten Schaltstellung nicht auf den Lichtempfänger zu reflektieren. Dies ist eine optisch einfache und zuverlässige Lösung zur Einrichtung verschiedener, durch die Recheneinheit erfassbarer Schaltzustände. Mittels Lichtleiter können grundsätzlich beliebige Geometrien bei der Anordnung realisiert werden, indem der Lichtleiter nur in der ersten Schaltstellung Licht vor dem Lichtemitter einkoppelt und/oder vor dem Lichtempfänger auskoppelt. Durch die Reflexion des Lichts auf den Lichtempfänger wird dort ein starkes Signal erzeugt und die Schaltstellung ist zuverlässig detektierbar.

Eine bevorzugte Ausführungsform einer solchen Reflexionsoptik kann vorsehen, dass der Lichtemitter und der Lichtempfänger das Licht im Wesentlichen entlang definierter Lichtausbreitungsrichtungen abstrahlen respektive empfangen und dass Lichtemitter und Lichtempfänger derart nebeneinander angeordnet sind, dass in der ersten Schaltstellung des Schalterelements ein genügend großer Anteil des abgestrahlten Lichts (zum Überschreiten der Schaltschwelle des Lichtempfängers) in dem optisch transparenten Abschnitt an einer oder mehreren bezogen auf die Lichtausbreitungsrichtung schräggestellten Reflexionsflächen auf den Lichtempfänger reflektiert wird und ohne das Schalterelement in der ersten (also beispielsweise der zweiten) Schaltstellung von dem Lichtemitter abgestrahltes Licht nicht in dem Lichtempfänger empfangen wird, d.h. kein über der Schaltschwelle des Lichtempfängers liegender Anteil des Lichts.

Gemäß einer einfachen Ausführungsform können die Lichtausbreitungsrichtungen von dem Lichtemitter und zu dem Lichtempfänger parallel verlaufen und das Schalterelement zur Reflexion des Lichts trapezförmig ausgebildet sein.

Gemäß einer Ausführungsform können zwei Reflexionsflächen des Schalterelements, bei parallel verlaufenden Lichtausbreitungsrichtungen, jeweils um 45° aufeinander zugeneigt, in dem Strahlengang des Lichts vor dem Lichtemitter und dem Lichtempfänger vorgesehen sein. Weil der Einfallswinkel bei einer Reflexion gleich dem Ausfallswinkel ist, wird das Licht von dem Lichtemitter in dieser ersten Schaltstellung des Schalterelements direkt auf den Lichtempfänger reflektiert. In der zweiten Schaltstellung des Schalterelements befinden sich die schräggestellten Reflexionsflächen nicht im Strahlengang des Lichts. Entsprechend wird das von dem Lichtemitter ausgesendete Licht im Lichtempfänger nicht detektiert.

Bei nicht parallelen Lichtausbreitungsrichtungen können die Reflexionsflächen anders und in einem entsprechend angepassten Winkel (d.h. Winkeln der Reflexionsflächen, die nicht 45° betragen, beispielsweise bei weiteren Reflexionen entlang der Lichtausbreitungsrichtung) zueinander ausgerichtet sein. Die Optik kann durch den Fachmann aufgrund des bekannten physikalischen Reflexionsgesetzes (Einfallswinkel gleich Ausfallswinkel) entsprechend angepasst werden.

Auch wenn diese Ausführungsform eine besonders bevorzugte Optik des optischen Schalters darstellt, ist die Erfindung nicht auf diese Ausführungsform beschränkt. Alternative Ausführungsformen eines erfindungsgemäßen optischen Schalters sind möglich und werden von der Erfindung mit erfasst.

Die hier beschriebene Ausführungsform stellt eine besonders bevorzugte Ausführungsform der Erfindung dar, weil ein besonders zuverlässiges Detektieren der Schalterstellung möglich ist. Dazu kann vorgesehen sein, dass der Lichtemitter und der Lichtempfänger optisch voneinander abgeschirmt in dem Gehäuse angeordnet sind, bspw. durch sich optisch dichte Blenden oder Einhausungen, die sich bis an eine Gehäusewand erstrecken.

Bei einer besonders bevorzugten Ausführungsform können zum Lichtaustritt in der Gehäusewand vor dem Lichtemitter und zum Lichteintritt in der Gehäusewand vor dem Lichtempfänger separate optisch transparente Abdeckungen vorgesehen sein. Hierdurch lässt sich eine besonders zuverlässige bauliche Abschirmung des Lichtempfängers von dem Lichtempfänger erreichen. Grundsätzlich kann eine gemeinsame optisch transparente Abdeckung vorgesehen sein, weil der durch eine gemeinsame Abdeckung (bspw. durch Mehrfachreflexion) reflektierte oder gestreute Lichtanteil klein ist.

Insbesondere wenn Lichtemitter und/oder Lichtempfänger nicht unmittelbar hinter der Gehäusewand respektive der transparenten Abdeckung des optischen Schalters in der Gehäusewand im Gehäuse angeordnet sind, können erfindungsgemäß vor dem Lichtemitter und/oder Lichtempfänger jeweils ein Lichtleiter angeordnet sein. Der Lichtleiter führt das ausgestrahlte und/oder empfangene Licht und gibt besonders definierte Lichtausbreitungsrichtungen vor. Auch hierdurch wird unerwünschte Lichtstreuung vermieden. Außerdem können der Lichtemitter und/oder Lichtempfänger besonders kostengünstig auf einer Platine der Vorrichtung zusammen mit anderen elektrischen und angeordnet sein, unabhängig von der Optik des optischen Schalters.

Für eine besonders zuverlässige Ermittlung der Schaltstellung des optischen Schalters kann die Recheneinheit dazu eingerichtet sein, den Lichtemitter zum Aussenden einer vorgegebenen Anzahl von Lichtpulsen anzusteuern und die Anzahl der in dem Lichtempfänger (zur gleichen Zeit) empfangenen Lichtpulse zu erfassen und auszuwerten. Bei der Auswertung kann die Recheneinheit erfindungsgemäß dazu eingerichtet sein, den ersten Schaltzustand zu erkennen, wenn die Anzahl der empfangenen Lichtpulse größer als ein erster Grenzwert ist, und den zweiten Schaltzustand zu erkennen, wenn die Anzahl der empfangenen Lichtpulse kleiner als ein zweiter Grenzwert ist. Hierdurch kann der Schaltzustand auch bei Störsignalen in dem Lichtempfänger zuverlässig erkannt werden.

Erfindungsgemäß können der erste und der zweite Grenzwert gleich sein, bspw. etwa der Hälfte der Anzahl der erzeugten Lichtpulse entsprechen. Es ist jedoch erfindungsgemäß bevorzugt, dass der erste Grenzwert größer ist als die Hälfte der Anzahl der erzeugten Lichtpulse und der zweite Grenzwert kleiner ist als Hälfte der Anzahl der erzeugten Lichtpulse. Wenn etwa die Hälfte der tatsächlich erzeugten Lichtpulse erfasst wird, spricht dies für ein großes Störsignal, bei dem der Schaltzustand des optischen Schalters nicht zuverlässig erfasst werden kann. Beispielsweise kann der erste Grenzwert bei etwa 2/3 der Anzahl der erzeugten Lichtpulse und der zweite Grenzwert bei etwa 1/3 der Anzahl der erzeugten Lichtpulse gewählt werden. Eine solche Hysterese bei der Auswertung dient dazu, die Schaltzustände stabiler abzutasten.

Eine sinnvolle Anzahl von erzeugten Lichtpulsen liegt für viele Anwendungen bei etwa 10. Beispielsweise können dann der erste Schaltzustand bei einer Anzahl von mehr als 7 erfassten Lichtpulsen und der zweite Schaltzustand bei einer Anzahl weniger als 3 erfassten Lichtpulsen erkannt werden.

Für ein einfaches Erfassen und Zählen der Lichtpulse kann der Lichtempfänger gemäß einer bevorzugten Ausführungsform an einen Komparator der Recheneinheit angeschossen sein, der die Höhe des von dem Lichtempfänger ausgegebenen Signals mit einem Schwellenwert vergleicht und bei jedem Überschreiten des Schwellenwerts einen Zähler hochzählt. Dies kann durch eine analoge oder digitale Schaltung realisiert werden. Bei einer digitalen Schaltung kann der Komparator als Eingang eines Prozessors der Recheneinheit ausgebildet sein. Die Recheneinheit kann dazu eingerichtet sein, den Zähler des Komparators jeweils vor einem neuen Aussenden der Anzahl von Lichtpulsen zurückzusetzen.

Gemäß einer besonders bevorzugten Ausführungsform der Erfindung kann der Lichtempfänger über einen Bandpass (Bandpassfilter) an die Recheneinheit angeschlossen sein. Hierdurch wird ein Gleichlichtanteil aus dem in dem Lichtempfänger defektierten Licht herausgefiltert. Erfindungsgemäß kann die Recheneinheit dazu eingerichtet sein, den Lichtemitter zur Aussendung der Lichtpulse mit einer definierten Frequenz anzusteuern. Das von dem Lichtempfänger ausgegebene Signal hat damit auch eine definierte, je nach elektronischer Verarbeitung bspw. dieselbe, Frequenz. Signale des Lichtempfängers, die nicht diese Frequenz haben, sind Störsignale (Gleichlicht im Sinne von Dauerlicht oder Lichtsignale anderer Frequenz). Derartige Störsignale werden durch den Bandpass aus dem Signal herausgefiltert. Ein Bandpass ist eine Schaltung oder ein Filter, die oder der nur Signale eines bestimmten Frequenzbands durchlässt. In einer einfachen Form besteht ein Bandpass aus einer Kombination von hintereinander geschalteten Hochpassfilter und Tiefpassfilter. Der Hochpassfilter filtert niedrige Frequenzen aus dem Signal, und der Tiefpassfilter filtert hohe Frequenzen aus dem Signal. So lässt sich ein Frequenzband einstellen, das den Filter passiert. Dies kann durch eine analoge oder digitale Schaltung realisiert werden. Bei einer digitalen Schaltung kann der Bandpass als Eingang eines Prozessors der Recheneinheit ausgebildet sein.

Gemäß einer weiteren, bevorzugten Ausführungsform der Erfindung können der Lichtemitter und der Lichtempfänger des optischen Schalters auch eine optische Kommunikationsschnittstelle bilden. Die optische Kommunikationsschnittstelle kann bspw. zusammen mit einem Inbetriebnahme- und Kommunikationsgerät bei der Installation, Inbetriebnahme und/oder Wartung der Vorrichtung verwendet werden. Gemäß einer erfindungsgemäß bevorzugten Ausbildung des optischen Schalters ist die optische Kommunikationsschnittstelle in jeder Schaltstellung des Schalterelements nutzbar. Dazu ist das Schalterelement dazu ausgebildet, dass es in jeder Schaltstellung höchstens einen Teil des Lichts des Lichtemitters dem Lichtempfänger zuleitet und zumindest ein Teil des Lichts von dem Lichtemitter von dem Gehäuse weg abstrahlt und den Lichtempfänger zumindest nicht vollständig optisch abdeckt. Zur Unterscheidung von Kommunikation über die Kommunikationsschnittstelle (bspw. eine optische Schnittstelle mit Verwendung von Infrarotlicht) und die Aussendung der Signalpulse zum Abtasten des optischen Schalters kann die Kommunikation über die optische Kommunikationsschnittstelle mit einer ersten Frequenz moduliert werden und das Aussenden der Signalpulse mit einer zweiten Frequenz erfolgen, die von der ersten Frequenz verschieden ist. Hierdurch lassen sich die Signale der ersten und der zweiten Frequenz beim Empfang und in der Recheneinheit bei der Verarbeitung der Signale unterscheiden.

Gemäß einer bevorzugten Ausführungsform kann hierfür vorgesehen sein, dass durch das Schalterelement in der ersten Schaltstellung keine Totalreflexion des ausgesendeten Lichts erfolgt. Dies kann durch eine Textur in der Reflexionsfläche und/oder eine Abdeckung nur eines Teils des Lichtstrahls durch die Reflexionsfläche des Schalterelements erfolgen. Die Reflexionsfläche kann an einem Übergang eines ersten (beispielsweise optisch dichteren) transparenten Mediums zu einem zweiten (beispielsweise optisch weniger dichten) transparenten Medium (bspw. Luft) ausgebildet sein. Die ersten und zweiten optisch transparenten Medien haben also unterschiedliche Brechungsindizes. Die Reflexionsfläche kann auch als spiegelnde (optisch nicht transparente) Fläche ausgebildet sein (sofern diese nur einen Teil des ausgesendeten Lichtstrahls abdeckt.)

Um den optischen Schalter (und ggf. die optische Kommunikationsschnittstelle) unempfindlich gegenüber Lichteinflüssen aus dem optisch sichtbaren Frequenzbereich zu machen, kann vorgesehen sein, dass das Licht, das von dem Lichtemitter ausgesendet und dem Lichtempfänger empfangen wird, Infrarotlicht ist. Entsprechend können der Lichtemitter als Infrarot-Leuchtdiode (IR-Leuchtdiode) und der Lichtempfänger als Infrarot-Fotodiode (IR-Fotodiode) oder Infrarot-Fototransistor (IR-Fototransistor) ausgebildet sein. Der Lichtempfänger kann unempfindlich gegenüber Lichtanteilen aus anderen Wellenlängenbereichen, bspw. dem sichtbaren Licht, sein. Dies kann durch einen nur für den IR-Wellenlängenbereich empfindlichen Fototransistor oder durch einen IR-Filter vor dem Fototransistor erreicht werden.

Weitere Vorteile, Merkmale und Anwendungsmöglichkeiten der Erfindung ergeben sich auch aus der nachfolgenden Beschreibung von Ausführungsbeispielen und der Zeichnung. Dabei gehören alle beschriebenen und/oder bildlich dargestellten Merkmale zusammen oder in beliebiger fachmännisch sinnvoller Kombination zum Gegenstand der Erfindung, auch unabhängig von ihrer Zusammenfassung in beschriebenen bzw. dargestellten Ausführungsbeispielen oder in den Ansprüchen.
- Fig. 1: zeigt schematisch eine Ausführungsform einer als Rauchwarnmelder ausgebildeten Vorrichtung für eine Gebäudeinstallation in einer Aufsicht von oben.
- Fig. 1a: zeigt schematisch den optischen Schalter der Vorrichtung nach Fig. 1 in einer zweiten Schaltstellung.
- Fig. 1b: zeigt schematisch den optischen Schalter der Vorrichtung nach Fig. 1 in einer ersten Schaltstellung.
- Fig. 2a: zeigt schematisch die Vorrichtung nach Fig. 1 in einer Seitenansicht mit dem optischen Schalter in der zweiten Schaltstellung entsprechend Fig. 1a.
- Fig. 2b: zeigt schematisch die Vorrichtung nach Fig. 1 in einer Seitenansicht mit dem optischen Schalter in der ersten Schaltstellung entsprechend Fig. 1b.
- Fig. 3: zeigt schematisch den optischen Schalter der Vorrichtung nach Fig. 1 in einer Schnittdarstellung entlang der Linie A-A aus der Richtung R_{A} entsprechend Fig. 1.
- Fig. 4: zeigt schematisch den optischen Schalter der Vorrichtung nach Fig. 1 in einer Schnittdarstellung entlang der Linie B-B aus der Richtung R_{B} entsprechend Fig. 1.
- Fig. 5: zeigt schematisch das Gehäuse der Vorrichtung nach Fig. 1 mit einer Platine und Funktionseinheiten der Vorrichtung.

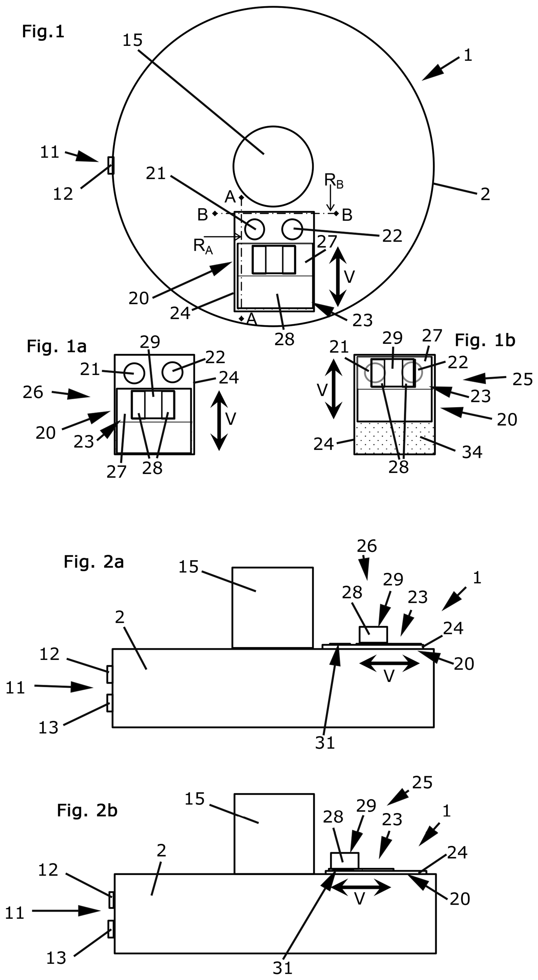

Die in Fig. 1 gezeigte Vorrichtung 1 für eine Gebäudeinstallation weist ein Gehäuse 2 auf, das vorzugsweise in einem Gebäude an einer Montagefläche festlegbar ist. Die (in der Zeichnung nicht dargestellte) Montagefläche kann eine Wand oder Decke vorzugsweise im Gebäudeinneren sein. Auch eine Montage an festgelegten oder mobilen Gegenständen, wie Heizkörper, Heizungsanlage, Möbel oder dergleichen, ist möglich.

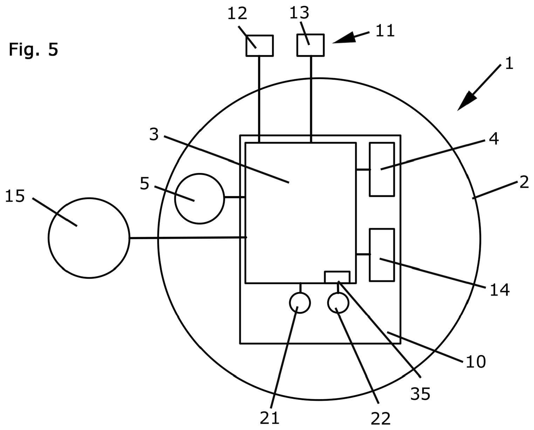

In dem Gehäuse 2 sind, wie in Fig. 5 dargestellt, eine Recheneinheit 3 und eine Energieversorgungseinheit 4, und eine Detektorkammer 5 angeordnet.

Die Recheneinheit 3 ist zur Steuerung der Vorrichtung 1 eingerichtet. Dies schließt insbesondere steuerbare Elemente oder Teile der Vorrichtung 1 ein, die noch genauer erläutert werden.

Die Energieversorgungseinheit 4 ist dazu ausgebildet, die Recheneinheit 3 und weitere elektrische Einheiten der Vorrichtung, die noch genauer erläutert werden, mit elektrischer Energie (insbesondere Spannung und Strom) zu versorgen. Die Recheneinheit 3 und die Energieversorgungseinheit 4 können auf einer Platine 10 in dem Gehäuse 2 angeordnet sein, ggf. aber auch anderweitig in dem Gehäuse 2 festgelegt sein. Vorzugsweise ist das Gehäuse 2 im Gebrauch (ggf. abgesehen von funktionsnotwendigen Öffnungen) geschlossen. Dazu kann das Gehäuse 2 bspw. zweiteilig aufgebaut sein mit einem Gehäuseunterteil, an dem auch die Platine 10 mit den auf der Platine 10 angeordneten Elementen festgelegt sein kann, und einem Gehäuseoberteil, das mit dem Gehäuseunterteil zerstörungsfrei lösbar und verbindbar ist unter Ausbildung eines durch das Gehäuse 2 umhüllten und vorzugsweise geschlossenen Innenraums, wie bereits eingangs beschrieben. An dem Gehäuse 2 angeordnete oder angebrachte weitere Elemente der Vorrichtung können an irgendeinem Gehäuseteil festgelegt sein, insbesondere an dem Gehäuseoberteil und/oder dem Gehäuseunterteil. Bestimmte Elemente der Vorrichtung können sowohl Teile aufweisen, die an dem Gehäuseoberteil angeordnet sind, als auch Teile, die an dem Gehäuseunterteil angeordnet sind. Allgemeiner ausgedrückt kann ein Element der Vorrichtung mehrere Teile aufweisen, die an jeweils verschiedenen Gehäuseteilen angeordnet sind.

Die Energieversorgungseinheit 4 kann eine autarke Energieversorgung, bspw. eine Batterie oder einen Akkumulator, umfassen und/oder eine kabelgebundene Energieversorgung mit bspw. einem Anschlusskabel, das zum Anschluss an ein Stromnetz durch das Gehäuse 2 durchgeführt ist.

Erfindungsgemäß ist an der Vorrichtung 1 ein Schalter 20 als ein weiteres Element der Vorrichtung 1 vorgesehen. Der Schalter 20 ist außen am Gehäuse 2 angeordnet und mechanisch betätigbar, d.h. durch mechanische Einwirkung auf Elemente des Schalters 20 schaltbar. Der Schalter 20 hat mindestens zwei Schaltstellungen, und in dem hier dargestellten Beispiel entsprechend einer einfachen, erfindungsgemäß bevorzugten Ausführungsform genau zwei Schaltstellungen.

Der Schalter 20 ist erfindungsgemäß als optischer Schalter mit einem Lichtemitter 21 und einem Lichtempfänger 22 ausgebildet, wie in Fig. 1 dargestellt. Lichtemitter 21 und Lichtempfänger 22 sind in dem hier dargestellten Ausführungsbeispiel auch auf der Platine 10 angeordnet, wie in Fig. 5 dargestellt. Die Erfindung ist auf diese kostengünstige und erfindungsgemäß bevorzugte Anordnung aber nicht beschränkt. Der Lichtemitter 21 und der Lichtempfänger 22 sind zur Steuerung mit der Recheneinheit 3 verbunden. Die Recheneinheit 3 ist entsprechend dazu eingerichtet, den Lichtemitter 21 zum Aussenden von Licht ein- und auszuschalten und in dem Lichtempfänger 22 auftreffendes Licht zu detektieren und zu erfassen. Dies wird später noch genauer beschrieben. Lichtemitter 21 und Lichtempfänger 22 sind in dem Gehäuse 2, bspw. auf der Platine 10, erfindungsgemäß beabstandet voneinander angeordnet.

Der Schalter 20 weist erfindungsgemäß ein außen am Gehäuse 20 mechanisch verstellbares Schalterelement 23 auf. In dem dargestellten Ausführungsbeispiel ist das Schalterelement 23 in einer durch einen Doppelpfeil dargestellten Verschieberichtung V verschiebbar in einer Verschiebeführung 24 des Schalters 20 geführt.

In einer ersten mechanischen Schaltstellung 25 des Schalterelements 23 (vgl. Fig. 1b) ist der optische Schalter 20 erfindungsgemäß dazu ausgebildet, von dem Lichtemitter 21 ausgesendetes Licht dem Lichtempfänger 22 zuzuleiten. Dieses dem Lichtempfänger 22 zugeleitete Licht wird durch die Recheneinheit 3 detektiert. Die Recheneinheit 3 ermittelt so die erste Schaltstellung 25 des optischen Schalters 20, respektive die erste Schaltstellung 25 des Schalterelements 23.

In einer zweiten mechanischen Schaltstellung 26 des Schalterelements 23 (vgl. Fig. 1a) ist der optische Schalter 20 erfindungsgemäß dazu ausgebildet, von dem Lichtemitter 21 ausgesendetes Licht dem Lichtempfänger 22 nicht zuzuleiten. Indem der Lichtempfänger 22 das ausgesendete Licht nicht detektiert, ermittelt die Recheneinheit 3 die zweite Schaltstellung 26 des optischen Schalters 20, respektive die zweite Schaltstellung 26 des Schalterelements 23. Dies ist möglich, weil die Recheneinheit 3 den Lichtemitter 21 zur Aussendung der Lichtpulse zu bekannten Zeitpunkten ansteuert. Zu genau diesen Zeitpunkten empfängt der Lichtempfänger 22 in der ersten Schaltstellung 25 des Schalterelements 23 die Lichtpulse. Werden zu genau diesen Zeitpunkten keine Lichtpulse oder keine ausreichende Anzahl von Lichtpulsen empfangen, befindet sich das Schalterelement 23 in der zweiten Schaltstellung 26. Auf diese Weise ermittelt die Recheneinheit 3 die Schaltstellung 25, 26 des Schalters 20.

In der in diesem Ausführungsbeispiel beschriebenen Ausführungsform des Schalterelements 23 ist das Schalterelement 23 dazu ausgebildet, in der ersten Schaltstellung 25 von dem Lichtemitter 21 ausgesendete Lichtstrahlen auf den Lichtempfänger 22 zu reflektieren und in der zweiten Schaltstellung nicht auf den Lichtempfänger 22 zu reflektieren. Grundsätzlich kann dies durch verschiedene in dem Schalterelement 23 hierfür ausgebildete Optiken erreicht werden. Die hier konkret vorgeschlagene Optik sieht vor, dass das Schalterelement 23 zumindest einen optisch transparenten Abschnitt 27 aufweist, in den das vom dem Lichtemitter 21 abstrahlte (ausgesendete) Licht in der ersten Schaltstellung 25 eingekoppelt wird und nacheinander an zwei schräggestellten Reflexionsflächen 28 auf den Lichtempfänger 22 reflektiert wird.

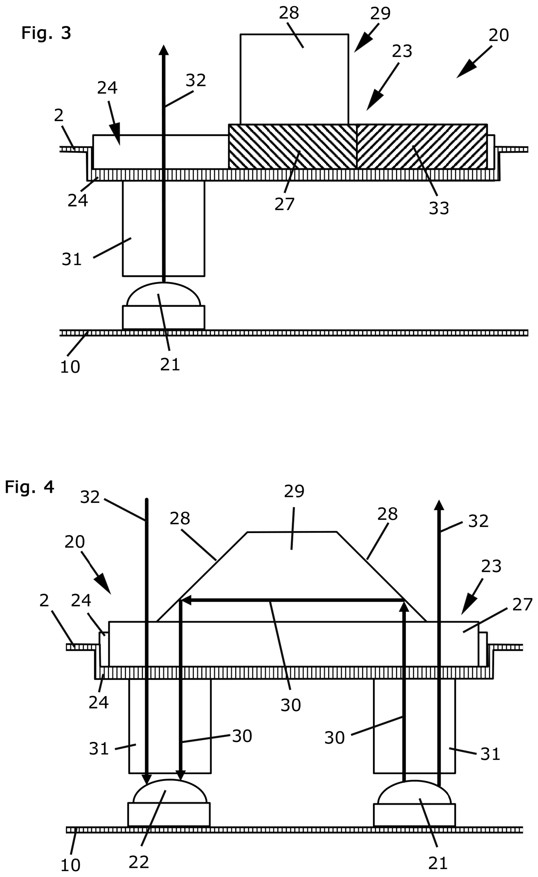

Der Strahlengang (Lichtausbreitungsrichtung) für diese Ausführungsform wird nachfolgend mit Bezug auf Fig. 4 näher beschrieben. Fig. 4 zeigt einen Querschnitt durch den optischen Schalter 20 der Vorrichtung 1 entlang des Schnitts B-B in der Sichtrichtung R_{B}, wie in Fig. 1 angegeben. Der optische Schalter 20 ist außen auf dem Gehäuse 2 angeordnet. Die Verschiebeführung 24 des Schalters 20 ist vorzugsweise einteilig mit dem Gehäuse 2 ausgebildet. In der Verschiebeführung 24 ist das Schalterelement 23 außen auf dem Gehäuse 2 gehalten und in Verschieberichtung V (in der Darstellung von Fig.4 senkrecht zu der Darstellungsebene) durch mechanische Krafteinwirkung verschiebbar gelagert. Der Schnitt B-B der Darstellung verläuft durch die Verschiebeführung 24 und zeigt die Stirnseite des optisch transparenten Abschnitts 27 des Schalterelements 23. An dem optisch transparenten Abschnitt 27, vorzugsweise einteilig mit diesem ausgebildet, ist auf der dem Gehäuse 2 abgewandten Seite des Schalters eine Trapezoptik 29 mit den Reflexionsflächen 28 ausgebildet. Die Reflexionsflächen 28 sind einander gegenüberliegend mit derselben Neigung von 45° aufeinander zu geneigt (relativ zur Lichtausbreitungsrichtung 30) in der Trapezoptik 29 ausgebildet.

Der Neigungswinkel von 45° ergibt sich durch die Lichtausbreitungsrichtungen 30 des von dem Lichtemitter 21 ausgesendeten Lichts und des von dem Lichtempfänger 22 empfangenen Lichts. Aufgrund des physikalischen Reflexionsgesetzes (Einfallswinkel gleich Ausfallswinkel) bei dem Auftreffen eines Lichtstrahls auf eine reflektive Oberfläche wird das ausgesendete Licht von dem Lichtemitter 21 durch die Trapezoptik 29 zweifach reflektiert und räumlich versetzt in entgegengesetzter Richtung dem Lichtempfänger 22 zugeleitet. Bei nicht parallelen Lichtausbreitungsrichtungen 30 von dem Lichtemitter 21 und zu dem Lichtempfänger 22 (in der Darstellung senkrechte Striche) können die Trapezoptik 29 und/oder die Ausrichtung (Winkel) der Reflexionsflächen 28 durch den Fachmann entsprechend dem physikalischen Reflexionsgesetz geeignet angepasst werden. Eine nicht parallele Lichtausbreitungsrichtung liegt bspw. bei (als SMD Bauteil oder diskret ausgestalteten) Infrarotleuchtdioden vor. Diese strahlen das Licht nahezu halbkugelförmig ab. Vorzugsweise wird der überwiegende Anteil der ungerichtet ausgesendeten Lichtstrahlen mit Lichtleitern in die bevorzugte Richtung gelenkt. Dies ist für die Funktionsweise des Schalters optional.

In dem beschriebenen Ausführungsbeispiel sind Lichtemitter 21 und Lichtempfänger 22 auf der (einen gemeinsamen) Platine 10 angeordnet (als funktional notwendiger Teil des optischen Schalters 20, der ein Element der Vorrichtung 1 ist). Vor den Lichtemitter 21 und Lichtempfänger 22 sind (als optionale Teile des optischen Schalters 20) Lichtleiter 31 vorgesehen, die das ausgesendete und empfange Licht in den definierten Lichtausbreitungsrichtungen 30 führen und unerwünschte Lichtstreuung reduzieren. Zur Vermeidung von Streulicht können um den Lichtemitter 21 und/oder den Lichtempfänger 22 auch optisch nicht durchlässige Einhausungen vorgesehen sein, die in dieser Ausführungsform nicht dargestellt sind.

Die Lichtführungen 31 sind durch Öffnungen in der Verschiebeführung 24 als Teil der Wandung des Gehäuses 2 durchgeführt und schießen diese Öffnungen. Aufgrund der Anordnung des Schnitts B-B sind diese Öffnungen in Fig. 4 nicht dargestellt. Das dem Lichtemitter 21 bzw. Lichtempfänger 22 gegenüberliegende Ende des Lichtleiters 31 liegt zum Einkoppeln des Lichts in der ersten Schaltstellung 25 des Schalterelements 23 vorzugsweise unmittelbar an dem optisch transparenten Abschnitt 27 des Schalterelements 23 an. Damit bilden die Lichtleiter 31 gleichzeitig eine optisch transparente Abdeckung im Bereich des optischen Schalters 20 zum Schließen des Gehäuses 2. Das Schalterelement 23 ist (auch) auf der durch eine Stirnseite der Lichtleiter 31 gebildeten Abdeckung bewegbar, in diesem Ausführungsbeispiel verschiebbar, angeordnet.

Die zuvor beschriebene erste Schaltstellung 25 des Schalterelements 23 mit dem optisch transparenten Abschnitt 27 mit Trapezoptik 29 und Reflexionsflächen 28 oberhalb von Lichtemitter 21 und Lichtempfänger 22 ist in der Seitenansicht der Vorrichtung 1 in Fig. 2b dargestellt.

In Fig. 2a ist die zweite Schaltstellung 26 des Schalterelements 23 in dem Schalter 20 dargestellt, in dem die Trapezoptik 29 mit den Reflexionsflächen 28 nicht über den Lichtemitter 21 und Lichtempfänger 22 respektive den jeweils zugehörigen Lichtemittern 31 angeordnet ist.

Die zugehörige Schnittdarstellung durch den optischen Schalter 20 entlang des Schnitts A-A aus der Blickrichtung R_{A} ist in Fig. 3 gezeigt, wobei gleiche Teile mit denselben Bezugszeichen bezeichnet sind wie in Fig. 4 und auf eine ausführliche Beschreibung der identischen Teile verzichtet wird. In dieser zweiten Schaltstellung 26 ist das Schalterelement 23 mit dem optisch transparenten Abschnitt 27, der Trapezoptik 29 und der Reflexionsfläche 28 nicht vor dem Lichtemitter 21 respektive dem diesem zugeordneten Lichtleiter 31 angeordnet. Das von dem Lichtemitter 21 ausgesendete Licht tritt in der durch den Lichtleiter 31 vorgegebenen Lichtausbreitungsrichtung 32 (in einem graden Strahlengang) aus dem Lichtleiter 31 und Schalter 20 aus, ohne dass Licht über die Trapezoptik 29 dem Lichtempfänger 22 zugeleitet wird. Hierdurch erkennt die Recheneinheit 3 der Vorrichtung 1 die zweite Schaltstellung 26.

In Fig. 3 ist erkennbar, dass das Schalterelement 23 gemäß einem optional bevorzugten Merkmal in dieser Ausführungsform auch einen optisch nicht transparenten Abschnitt 33 aufweist, der vorzugweise parallel zur Verschieberichtung V neben dem optisch transparenten Abschnitt 27 angeordnet ist und den unter dem optisch nicht transparenten Abschnitt 33 liegenden Bereich der Verschiebeführung 24 in der jeweiligen Schaltstellung 25, 26 abdeckt. Dies kann zur Schalterstellungserkennung verwendet werden, indem ein Bereich 34 der Verschiebeführung in einer der Schaltstellungen (hier der ersten Schaltstellung 25) sichtbar ist (wie in Fig. 1a dargestellt) und in einer anderen der Schaltstellungen (hier der zweiten Schaltstellung 26) abdeckt ist (wie in Fig. 2a dargestellt). Gemäß einer optionalen Ausgestaltung kann der Bereich 34 auffällig (bspw. farblich hervorstechend, etwa rot) gestaltet sein, um die Schaltstellung einfach und schnell erkennbar anzuzeigen.

Der zuvor beschriebene Schalter 20 stellt eine bevorzugte Ausführungsform der Erfindung dar, mit einer bevorzugten Ausbildung des Schalterelements 23 und der in dem Schalter 20 verwendeten Optik (Trapezoptik 29 mit Reflexionsflächen 28). Die Erfindung lässt sich auch mit anders konstruierten Schalterelementen, Optiken und/oder Anordnungen von Lichtemitter und Lichtempfänger realisieren. Dies erschließt sich dem Fachmann im Rahmen seines Fachwissens. Beispielsweise kann auch ein Schieber als Schalterelement konstruiert werden, der seitlich, also mit um 90° gedrehter Schieberichtung, über die beiden Lichtleiter geschoben wird. Ebenso kann das optisch wirksame Schalterelement (Trapez) am Gehäuse drehbar gelagert sein und zum Schalten über die Lichtleiter gedreht werden. In einer dem Fachmann bekannten weiteren Ausführung kann ein beispielsweise im Halbkreis gebogener Lichtleiter zur Lichtführung in das Schalterelement integriert werden.

Zur Ermittlung der Schaltstellung 25, 26 des optischen Schalters 20 ist die Recheneinheit 23 dazu ausgebildet, durch den Lichtemitter 21 eine vorgegebene Anzahl von Lichtpulsen auszusenden und zeitgleich in dem Lichtempfänger 22 empfangene Lichtpulse zu detektieren. Werden während der Sequenz der Lichtpulse (gegeben durch die Anzahl der mit einer definierten Frequenz ausgegebenen Lichtpulse) die Lichtpulse in dem Lichtempfänger in einer Anzahl empfangen, die größer als ein vorgegebener erster Grenzwert ist, erkennt die Recheneinheit 3 den ersten Schaltzustand 25. Werden dagegen während der Sequenz der Lichtpulse die Lichtpulse in dem Lichtempfänger in einer Anzahl empfangen, die kleiner als ein vorgegebener zweiter Grenzwert ist, erkennt die Recheneinheit 3 den zweiten Schaltzustand 26. Ergänzend wird hierzu auf die vorstehende Beschreibung verwiesen.

Um die Sequenz der Lichtpulse in dem Empfänger gut zu erkennen und einen möglichen Gleichlichtanteil zu unterdrücken, ist in der in Fig. 5 dargestellten Ausführungsform der Lichtempfänger 22 über einen Eingang der Recheneinheit mit einem Bandpass 35 (Bandpassfilter) angeschlossen. Die Funktion des Bandpasses 35 wurde bereits erläutert. Hierauf wird verwiesen.

In der hier konkret beschriebenen Ausführungsform der Vorrichtung 1 werden der Lichtemitter 21 und der Lichtempfänger 22 parallel als optische Kommunikationsschnittstelle verwendet. Dazu können der Lichtemitter 21 als IR-Leuchtdiode und der Lichtempfänger 22 als IR-Fotodiode oder IR-Fototransistor ausgebildet sein. Sie bilden dann eine Infrarot-Kommunikationsschnittstelle, die als von der Recheneinheit 3 gesteuerte optische Kommunikations-Schnittstelle arbeitet. Auch hier wird auf die vorstehende Beschreibung verwiesen. In Fig. 4 ist dazu zu erkennen, dass die Reflexionsflächen 28 vor dem Lichtemitter 21 und dem Lichtempfänger 22 in der ersten Schaltstellung 25 jeweils nur einen Teil des Lichtstrahls erfassen, der entlang dem Strahlengang 30 in der ersten Schaltstellung 25 reflektiert wird.

Ein nicht von den Reflexionsflächen 28 erfasster Teil des Lichts tritt aus dem Gehäuse 2 der Vorrichtung 1 aus (von dem Lichtemitter 21 ausgesendetes Licht) bzw. in das Gehäuse 2 der Vorrichtung 1 ein (von dem Lichtempfänger 22 empfangenes Licht). Dieses Licht ist in Fig. 4 durch den Strahlengang 32 dargestellt. Dieses Licht kann zur Kommunikation der optischen bzw. Infrarot-Kommunikationsschnittstelle verwendet werden, wie bereits beschrieben. Auch hierauf wird ergänzend verwiesen.

Bei der in den Fig. 1 bis 5 konkret beschriebenen Ausführungsform der Vorrichtung 1 handelt es sich um eine Datenerfassungsvorrichtung in einem lokalen Gebäude-Kommunikationsnetzwerk. Diese ist mit einer Sensoreinheit 11 zur Klimadatenerfassung mit einem Temperatursensor 12 und einem Feuchtesensor 13 (Fig. 1 bis 3) ausgestattet, wobei der Temperatursensor 12 und der Feuchtsensor 13 außen an dem Gehäuse 2 festgelegt sind. Besonders bevorzugt können die Sensoreinheit 11 oder einzelne Sensoren 12, 13 der Sensoreinheit 11 auch innerhalb des Gehäuses 3 (beispielsweise innen auf der Platine, als integrierte elektronische Sensorbauteile und Teil der Elektronik) oder grundsätzlich entfernt von dem Gehäuse 2 angeordnet sein. Wie in Fig. 5 dargestellt, sind der Temperatursensor 12 und der Feuchtsensor 13 mit der Recheneinheit 3 verbunden, welche die Daten der Sensoren 12, 13 erfassen und verarbeiten kann.

Ferner weist die Vorrichtung 1 eine Sendeeinheit 14 auf, die zum Aussenden der erfassten Daten der Sensoreinheit in einem Gebäude-Kommunikationsnetz an einen lokalen Datensammler und/oder in einem Weitbereichsnetzwerk (WAN - Wide Area Network) und/oder in einem loT Funknetzwerk an eine zentrale Datensammelstelle einrichtbar ist. Dazu ist die Sendeinheit 14 an die Recheneinheit 3 angeschlossen, die das Aussenden der Daten steuert. In dieser Ausführungsform ist die Recheneinheit 3 weiter dazu ausgebildet ist, die Sendeeinheit 14 abhängig von der ermittelten Schaltstellung 25, 26 zum Aussenden zumindest des Teils der erfassten Daten einzurichten. Die Sendeeinheit 14 kann auch als Sende- und Empfangseinheit ausgebildet sein.

Damit kann ein Nutzer durch den Schalter 20 einfach Einstellungen zum Erheben und/oder Aussenden von seiner Wohnung erhobenen Daten vornehmen und die Einstellung übersichtlich außen am Gehäuse ablesen, ohne in einer Menüabfrage der Vorrichtung 1 oder in einem Online-Portal oder in einer App aufwendig nachschauen zu müssen.

Im beschrieben Ausführungsbeispiel ist die Vorrichtung 1 ein Rauchwarnmelder mit einer Rauch-Detektionskammer 5 (Detektorkammer), die innerhalb des Gehäuses 2 festgelegt und auch mit der Recheneinheit 3 verbunden ist. Signale oder Daten der Rauch-Detektionskammer 5 können auch durch die Sendeeinheit 14 übertragen werden. Soweit diese Signale oder Daten zur Hauptfunktion des Rauchwarnmelders gehören und beispielsweise funktions- oder sicherheitsrelevant sind, wird die Übertragung solcher Daten durch die Schaltstellung 25, 26 nicht beeinflusst. Insofern kann die Recheneinheit 3 dazu eingerichtet sein, auch nur einen Teil der durch Sensoreinheiten 11, 5 erfassten Daten der Vorrichtung 1 in Abhängigkeit von der Schaltstellung 25, 26 zu speichern und/oder zu übertragen oder nicht zu speichern und/oder zu übertragen. Ferner weist die als Rauchwarnmelder ausgebildete Vorrichtung 1 optional einen Hitzesensor 15 auf, der aus dem Gehäuse 2 herausragt und der Funktion als Rauch- bzw. Brandwarnmelder dient.

### Bezugszeichenliste:

- 1: Vorrichtung
- 2: Gehäuse
- 3: Recheneinheit
- 4: Energieversorgungseinheit
- 5: Rauch-Detektionskammer

- 10: Platine
- 11: Sensoreinheit
- 12: Temperatursensor
- 13: Feuchtesensor
- 14: Sendeeinheit
- 15: Hitzesensor
- 20: optischer Schalter
- 21: Lichtemitter
- 22: Lichtempfänger
- 23: mechanisch verstellbares Schalterelement
- 24: Verschiebeführung
- 25: erste Schaltstellung
- 26: zweite Schaltstellung
- 27: optisch transparenter Abschnitt
- 28: Reflexionsfläche
- 29: Trapezoptik
- 30: Lichtausbreitungsrichtung, Strahlengang in der ersten Schaltstellung
- 31: Lichtleiter
- 32: Lichtausbreitungsrichtung, Strahlengang
- 33: optisch nicht transparenter Abschnitt
- 34: in zweiter Schaltstellung 26 abgedeckter Bereich der Verschiebführung
- 35: Bandpass

- V: Verschiebrichtung

## Patentansprüche

1. Vorrichtung für eine Gebäudeinstallation aufweisend
ein Gehäuse (2), eine Recheneinheit (3), die zur Steuerung der Vorrichtung (1) eingerichtet ist, und eine Energieversorgungseinheit (4), wobei die Recheneinheit (3) und die Energieversorgungseinheit (4) innerhalb des Gehäuses (2) angeordnet sind,
einen Schalter (20), der außen am Gehäuse (2) angeordnet und mechanisch betätigbar ist, wobei der Schalter (20) mit der Recheneinheit (3) verbunden ist und mindestens zwei Schaltstellungen (25, 26) aufweist, und wobei die Recheneinheit (3) zur Ermittlung der Schaltstellung (25, 26) des Schalters (20) eingerichtet ist,
**dadurch gekennzeichnet, dass**
der Schalter als optischer Schalter (20) mit einem Lichtemitter (21) und einem Lichtempfänger (22) ausgebildet ist, die in dem Gehäuse (2) beabstandet voneinander angeordnet sind, und der optische Schalter (2) ein außen an dem Gehäuse mechanisch verstellbares Schalterelement (23) aufweist,
wobei der optische Schalter (20) in einer ersten mechanischen Schaltstellung (25) des Schalterelements (23) von dem Lichtemitter (21) ausgesendetes Licht dem Lichtempfänger (22) zuleitet und
wobei der optische Schalter (20) in einer zweiten mechanischen Schaltstellung (26) des Schalterelements (23) von dem Lichtemitter (21) ausgesendetes Licht dem Lichtempfänger (22) nicht zuleitet.

2. Vorrichtung nach Anspruch 1, **dadurch gekennzeichnet, dass** die Vorrichtung (1) eine Datenerfassungsvorrichtung in einem lokalen Gebäude-Kommunikationsnetzwerk ist mit
einer Sensoreinheit (11) und/oder einer Empfangseinheit, die zum Erfassen von Daten eingerichtet ist, und
einer Sendeeinheit (14), die zum Aussenden zumindest eines Teils der erfassten Daten in dem Gebäude-Kommunikationsnetz an einen lokalen Datensammler und/oder in einem Weitbereichsnetzwerk an eine zentrale Datensammelstelle einrichtbar ist,
wobei die Recheneinheit (3) weiter dazu ausgebildet ist, die Sendeeinheit (14) abhängig von der ermittelten Schaltstellung (25, 26) zum Aussenden zumindest des Teils der erfassten Daten einzurichten.

3. Vorrichtung nach Anspruch 2, **dadurch gekennzeichnet, dass** die Recheneinheit (3) dazu ausgebildet ist, die Sendeeinheit (14) in genau einer der mindestens zwei Schaltstellungen (25, 26) nicht zum Erfassen, Speichern und/oder Aussenden zumindest des Teils der erfassten Daten einzurichten und in genau einer anderen der zumindest zwei Schaltstellungen (25, 26) zum Erfassen, Speichern und/oder Aussenden zumindest des Teils der erfassten Daten einzurichten.

4. Vorrichtung nach einem der vorhergehenden Ansprüche, **dadurch gekennzeichnet, dass** das Gehäuse (2) im Bereich des optischen Schalters (20) mit einer optisch transparenten Abdeckung geschlossen ist, wobei das Schalterelement (23) des optischen Schalters (20) bewegbar auf der optisch transparenten Abdeckung bewegbar angeordnet ist.

5. Vorrichtung nach einem der vorhergehenden Ansprüche, **dadurch gekennzeichnet, dass** mit dem optischen Schalter (20) genau zwei Schaltstellungen (25, 26) einstellbar sind.

6. Vorrichtung nach einem der vorhergehenden Ansprüche, **dadurch gekennzeichnet, dass** die Vorrichtung (1) ein Rauchwarnmelder, ein Verbrauchserfassungsgerät, ein Sensorgerät und/oder ein Datensammler ist.

7. Vorrichtung nach einem der vorhergehenden Ansprüche, **dadurch gekennzeichnet, dass** das Schalterelement (23) in der ersten Schaltstellung (25) von dem Lichtemitter (21) ausgesendete Lichtstrahlen auf den Lichtempfänger (22) reflektiert und in der zweiten Schaltstellung (26) nicht auf den Lichtempfänger (22) reflektiert.

8. Vorrichtung nach Anspruch 7, **dadurch gekennzeichnet, dass** der Lichtemitter (21) und der Lichtempfänger (22) das Licht im Wesentlichen entlang definierter Lichtausbreitungsrichtungen abstrahlen respektive empfangen und derart nebeneinander angeordnet sind, dass ohne das Schalterelement (23) in der ersten Schaltstellung (25) das von dem Lichtemitter abgestrahlte Licht nicht in dem Lichtempfänger empfangen wird, und dass das abgestrahlte Licht in der ersten Schaltstellung (25) des Schalterelements (23) an einer oder mehreren schräggestellten Reflexionsflächen (28) auf den Lichtempfänger (22) reflektiert wird.

9. Vorrichtung nach Anspruch 8, **dadurch gekennzeichnet, dass** die Lichtausbreitungsrichtungen (30, 32) von dem Lichtemitter (21) und zu dem Lichtempfänger (22) parallel verlaufen und dass das Schalterelement (23) zur Reflexion des Lichts eine Trapezoptik aufweist.

10. Vorrichtung nach einem der vorhergehenden Ansprüche, **dadurch gekennzeichnet, dass** vor dem Lichtemitter (21) und/oder dem Lichtempfänger (22) jeweils ein Lichtleiter (31) angeordnet ist.

11. Vorrichtung nach einem der vorhergehenden Ansprüche, **dadurch gekennzeichnet, dass** die Recheneinheit (3) dazu eingerichtet ist, den Lichtemitter (21) zum Aussenden einer vorgegebenen Anzahl von Lichtpulsen anzusteuern und die Anzahl der in dem Lichtempfänger (22) empfangenen Lichtpulse zu erfassen und auszuwerten, wobei
der erste Schaltzustand (25) erkannt wird, wenn die Anzahl der empfangenen Lichtpulse größer als ein erster Grenzwert ist und
der zweite Schaltzustand (26) erkannt wird, wenn die Anzahl der empfangenen Lichtpulse kleiner als ein zweiter Grenzwert ist.

12. Vorrichtung nach Anspruch 11, **dadurch gekennzeichnet, dass** der Lichtempfänger (22) an einen Komparator der Recheneinheit (3) angeschlossen ist, der dazu eingerichtet ist, die Höhe des von dem Lichtempfänger (22) ausgegebenen Signals mit einem Schwellenwert zu vergleichen und bei jedem Überschreiten des Schwellenwerts einen Zähler hochzuzählen.

13. Vorrichtung nach einem der Ansprüche 11 oder 12, **dadurch gekennzeichnet, dass** der Lichtempfänger (22) über einen Bandpass (35) an die Recheneinheit (3) angeschlossen ist.

14. Vorrichtung nach einem der vorhergehenden Ansprüche, **dadurch gekennzeichnet, dass** der Lichtemitter (21) und der Lichtempfänger (22) des optischen Schalters (20) auch eine optische Kommunikationsschnittstelle bilden.

15. Vorrichtung nach Anspruch 14, **dadurch gekennzeichnet, dass** durch das Schalterelement (23) in der ersten Schaltstellung (25) keine Totalreflexion des durch den Lichtemitter (1) ausgesendeten Lichts erfolgt.

16. Vorrichtung nach einem der vorhergehenden Ansprüche, **dadurch gekennzeichnet, dass** das Licht Infrarotlicht ist.
